Europäisches Patentamt

European Patent Office

Office européen des brevets

(19)

(11) Publication number: **0 421 608 A2**

(12) **EUROPEAN PATENT APPLICATION**

(21) Application number: **90309635.2**

(22) Date of filing: **04.09.90**

(51) Int. Cl.5: **H01L 21/205, H01L 21/20**

(30) Priority: **05.09.89 JP 228287/89**

(43) Date of publication of application:
**10.04.91 Bulletin 91/15**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Ando, Hideyasu**
**78-9, Torigaoka, Totsuka-ku**
**Yokohama-shi, Kanagawa 244(JP)**

(74) Representative: **Rackham, Stephen Neil et al**
**GILL JENNINGS & EVERY 53-64 Chancery**
**Lane**
**London WC2A 1HN(GB)**

(54) **Method of forming a vertical type superlattice layer of compound semiconductor.**

(57) A method of forming a vertical type superlattice layer (16) of first compound semiconductor AC (AlAs) thin layers (13) and second compound semiconductor BC (GaAs) thin layers (14) (wherein the elements A and C are atoms of group III, group II or group VI of the periodic table, and the element C is atom of group V, group VI or group II), on an atomic step surface of a vicinal single crystal compound semiconductor (GaAs) substrate (1), comprisas repeating the following process steps (a), (b), and (c) in sequence.

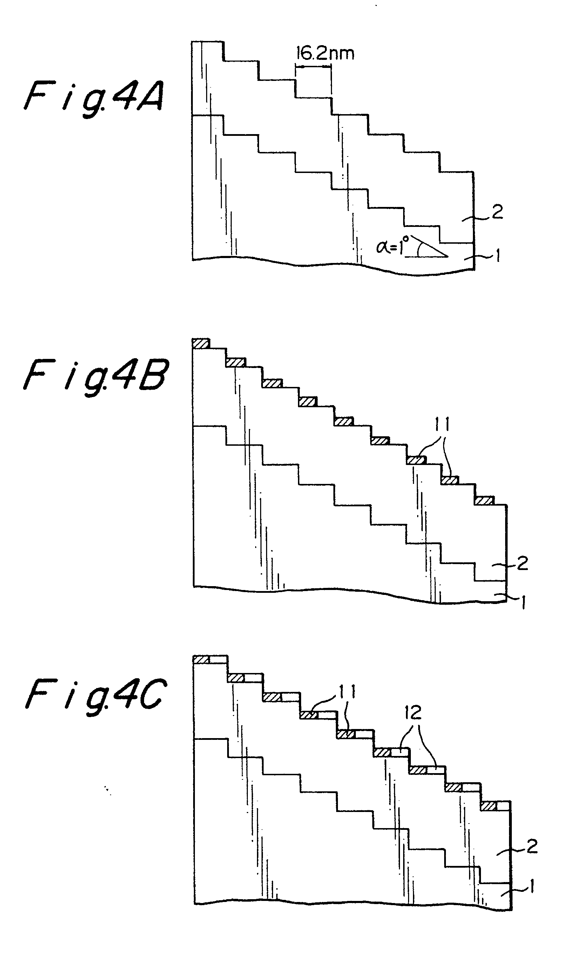

Step (a) supplying a first source gas containing the element A (TEA or TMA gas) to grow a single atomic A (Al) layer (11) on a half of the step width from a side of the atomic step under a growth duration control (Fig. 4B).

Step (b) supplying a second gas containing the element B (TEG or TMG gas) under a self-limiting condition of a single atomic layer, to form a single atomic B (Ga) layer (12) on the remaining portion of the step width (Fig. 4C).

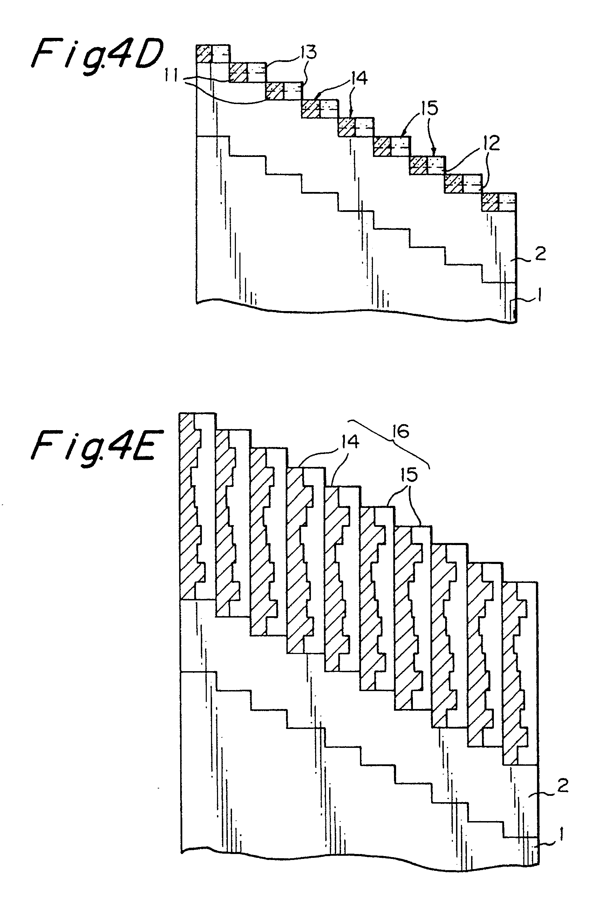

Step (c) supplying a third source gas containing the element C (AsH₃ gas) to combine the element C (As) with the single atomic A (Al) layer and with the single atomic B (Ga) layer, so as to form a single molecular layer (14) of the first compound semiconductor AC and a single molecular layer (15) of the second compound semiconductor BC, respectively (Fig. 4D).

This provides first compound semiconductor AC

(AlAs) thin layers (14) and second compound semiconductor BC (GaAs) thin layers (15) alternately set in a lateral (transverse) direction with one of the interfaces between the second compound semiconductor BC (GaAs) thin layers (15) and the first compound semiconductor AC (AlAs) thin layers (14) being completely flat and vertical in relation to the crystal substrate (1) (Fig. 4E).

Fig.4D

Fig.4E

EP 0 421 608 A2

# METHOD OF FORMING A VERTICAL TYPE SUPERLATTICE LAYER OF COMPOUND SEMICONDUCTOR

The present invention relates to a superlattice, and more particularly, to a method of forming a vertical type superlattice (e.g., GaAs/AlAs) layer of a compound semiconductor.

An attempt to form (epitaxially grow) a superlattice of alternately and laterally arranged GaAs/AlAs on a GaAs substrate, as the vertical type superlattice of a compound semiconductor, has been made (see, e.g., T. Fukui, M. Saito and Y. Tokura: Jap. J. Appl. Phys. Vol. 27, No. 7, July, 1988, pp. L1320 - L1322).

Hitherto, the vertical type superlattice is formed by using a metalorganic chemical vapor deposition (MOCVD) process as follows.

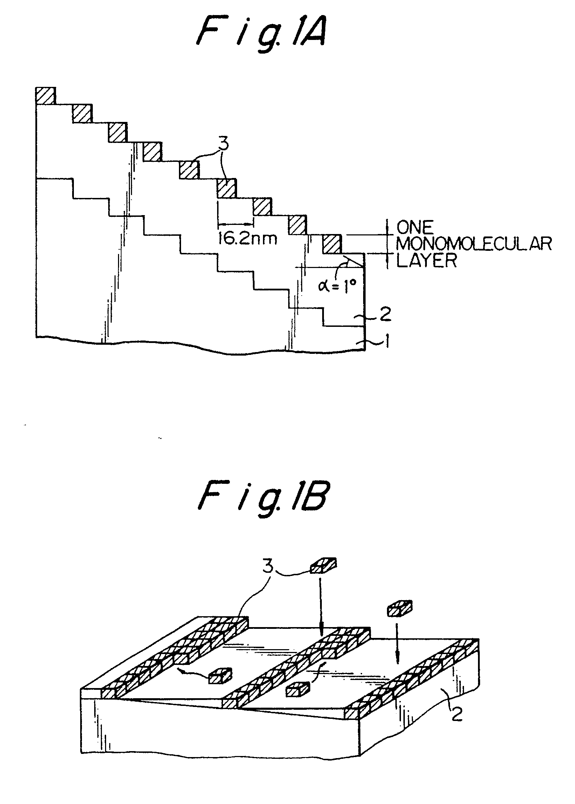

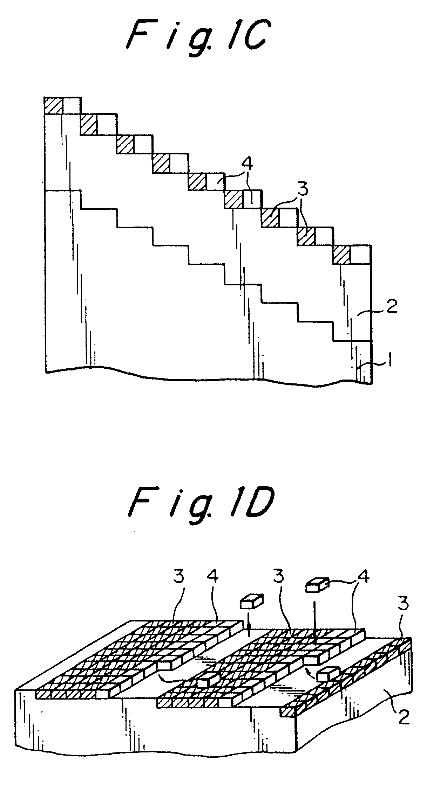

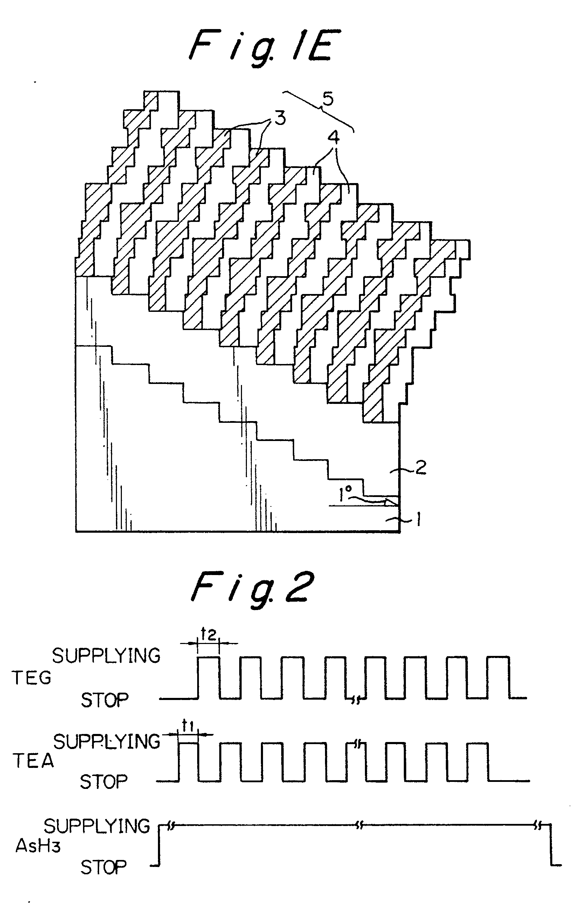

First, a single crystal GaAs ingot is cut into a vicinal substrate (an OFF substrate) having a slightly misoriented crystalline surface at an inclination of a few degrees (e.g., $\alpha = 1°$) from the (100) plane. As shown in Fig. 1A, the surface of the vicinal substrate 1 consists of atomic steps and terraces. On the GaAs vicinal substrate a GaAs buffer layer 2 is grown by an MOCVD process under a condition that a diffusion length of Ga atom is larger than a terrace width (step width). Although the substrate has a step height being not necessarily a single atomic layer height and has a terrace width with dispersion, as the buffer GaAs layer grows, the substrate surface is improved to consist of uniform and periodic single atomic steps having the step width of 16.2 nm at $\alpha = 1°$).

To form (grow) a GaAs/AlAs vertical type superlattice layer on the buffer GaAs layer 2 by a MOCVD process, source gases (arsine ($AsH_3$)-•triethylaluminum (TEA) and triethylgallium (TEG)) are supplied under a sequence control illustrated in Fig. 2. In this case, the $AsH_3$ gas is continuously supplied, and the TEA and TEG gases (group-III element source gases) are pulsatively and alternately supplied.

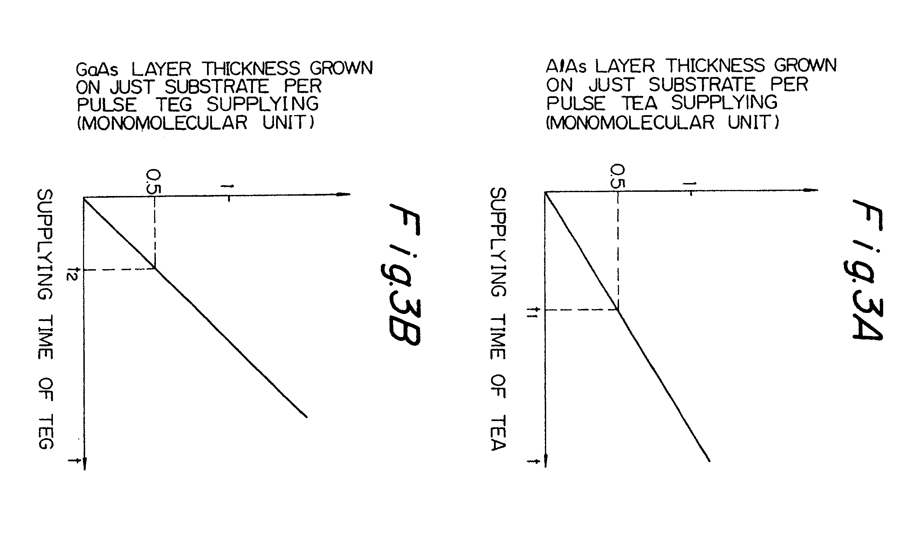

Following the $AsH_3$ gas, first, as the TEA gas is supplied, Al atoms diffuse on the surface of the buffer layer 2 and adhere preferentially to a step edge to grow in a lateral direction thereon, and As atoms adhere onto the Al atoms to form monomolecule layers 3, as shown in Figs. 1A and 1B. In a normal case, there is a relationship between an AlAs layer thickness (monomolecular unit) grown on a JUST-CUT (100) GaAs substrate and a TEA gas supplying duration, as shown in Fig. 3A. (The JUST-CUT substrate is a nonoriented substrate, e.g., (100) GaAs substrate.) When such a condition is applied on the misoriented substrate, a pulse feeding duration $t_1$ corresponding to a half of the terrace width formation of the AlAs layer on the step terrace is predetermined to form the AlAs monomolecular layer 3 in the lateral direction to the half distance (8.1 nm) of the terrace width (16.2 nm), as shown in Fig. 1A. Next, the flow of the TEA gas is stopped and the TEG is supplied. As a result, Ga atoms diffuse on the remaining exposed area of the buffer layer 2 and adhere preferentially to a step side of the grown AlAs layer to grow in a lateral direction thereon, and As atoms adhere onto the Ga atoms to form monomolecule layers 4, as shown in Figs. 1C and 1D. In this case, there is a relationship between a GaAs layer thickness (monomolecular unit) grown on a JUST GaAs substrate and a TEG gas supplying duration, as shown in Fig. 3B. When such a condition is applied to the misoriented substrate, a pulse supplying duration $t_2$ corresponding to a half terrace width formation of the GaAs layer on the step terrace is predetermined to form the GaAs monomolecular layer 4 in the lateral direction to the rest of the terrace width, as shown in Fig. 1C.

The above-mentioned AlAs layer growth and GaAs layer growth are alternately repeated to form a GaAs/AlAs superlattice 5 consisting of the AlAs layers 3 and GaAs layers 4 which extend in a vertical direction and are periodically arranged in a lateral (horizontal) direction, as shown in Fig. 1E.

In the above-mentioned formation method of the vertical type superlattice, since the growth rates (growth thicknesses per cycle) of AlAs layers 3 and GaAs layers 4 are proportional to the supplying duration of the raw source gases, as shown in Figs. 3A and 3B, it is necessary to precisely control the supplying durations of the raw source gases, so as to make a lateral growth distance just half of the terrace width. However, in practice, such a control is very difficult, for example, although about 40 atoms can be arranged in half (8.1 nm) of the terrace width (16.2 nm), the control accuracy of the raw source gas supplying durations being within ±1% leads to a dispersion of one or two atoms. Thus, the GaAs layer grows either to extend over the atomic step (terrace) width and on the AlAs layer formed on the neighboring lower step or two leave an uncovered portion of the terrace. Therefore, the formed vertical type superlattice, in practice, has a structure in which the interfaces of the AlAs layers 3 and GaAs layers 4 are inclined to the substrate 1 and are not flat, as shown in Fig. 1E. For example, if a number of the atoms arranged on the terrace per growth cycle is over by one atom, the interfaces may be inclined at 45°. It is difficult to use the vertical type superlattice having the inclined and nonflat interfaces for quantum effect devices (a quantum interference effect transistor or the like) which are expected to come into practical use.

An object of the present invention is to provide a method of forming a compound semiconductor vertical type superlattice layer provided with interfaces of first semiconductor thin layers and second semiconductor thin layers interfaces of which are vertical to the substrate surface and are improved with respect to flatness.

Another object of the present invention is to provide an improved compound semiconductor vertical type superlattice suitable for semiconductor devices.

The above-mentioned and other objects of the present invention are attained by providing a method of forming a vertical type superlattice layer of first compound semiconductor AC thin layers and second compound semiconductor BC thin layers (wherein the elements A and C are atoms of group III, group II or group VI of the periodic table, and the element C is atom of group V, group VI or group II), on an atomic step surface of a single crystal compound semiconductor substrate, comprising the step of repeating the following process steps (a), (b) and (c):

the process step (a) supplying a first source gas containing the element A to grow a single atomic A layer from the side of the atomic step in a lateral direction and on a portion (particularly, a half) of the atomic step width under a growing time control;

the process step (b) supplying a second source gas containing the element B, under a self-limiting condition, to form a single atomic B layer on the rest of the step width; and

the process step (c) supplying a third source gas containing the element C to combine the element C with the single atomic A layer and with the single atomic B layer, so as to form a single molecular layer of the first compound semiconductor AC and a single molecular layer of the second compound semiconductor BC, respectively; so that the first compound semiconductor AC thin layers and second compound semiconductor BC thin layers are alternately set in a lateral direction and one of the interfaces of each of the second compound semiconductor BC thin layers to the first compound semiconductor AC thin layers is flat and vertical to the crystal substrate.

According to the present invention, for forming an AC/BC superlattice, a supplying system (sequence) of source gases containing elements A, B, and C and growth conditions are controlled, to grow a single atomic layer A on a portion of an atomic step of the substrate, to grow a single atomic layer B on the rest under a self-limiting mechanism for preventing the thickness thereof from increasing (at this duration, the element (atoms) B deposits on the step only and does not deposit on the single atomic layer A on the neighboring lower atomic step), and then the element (atoms) C is deposited on the single atomic layers A and B, so as to form the monomolecular layers AC and BC, respectively. Thus, the monomolecular layer BC does not extend over the step (terrace) width and is not short for filling the remaining portion with the result that one of the interfaces of the monomolecular layer BC with the monomolecular layer AC is made flat and vertical to the substrate.

The atomic step surface is formed by epitaxially growing a buffer compound semiconductor layer on the single crystal compound semiconductor substrate having a vicinal surface.

The present invention will be more apparent from the description of the principle embodiment and preferred embodiments set forth below, with reference to the accompanying drawings, in which:

Figs. 1A to 1E are schematic sectional views of a compound semiconductor substrate with a vertical type superlattice layer in various stages of a conventional formation process of the superlattice layer;

Fig. 2 is a graph of a gas supplying sequence for controlling source gases to form a conventional vertical type superlattice layer;

Figs. 3A and 3B are graphs showing relationships between source gas supplying (cycle) durations and thickness of grown layers per cycle at the layer growth on a JUST substrate, respectively;

Figs. 4A to 4E are schematic sectional views of a compound semiconductor substrate with a vertical type superlattice layer in various stages of a formation process of the superlattice layer in accordance with the present invention;

Figs. 5A and 5B are graphs showing relationships between source gas supplying (cycle) durations and thickness of grown layers per cycle at the layer growth on a JUST substrate, respectively;

Fig. 6 is a schematic sectional view of a compound semiconductor substrate with an ideal vertical type superlattice layer formed in accordance with the present invention;

Fig. 7 is a schematic sectional view (without exaggeration of a vicinal angle) of a compound semiconductor substrate with a vertical type superlattice layer formed in accordance with the present invention;

Fig. 8 is a schematic view of a conventional vertical type MOCVD apparatus;

Fig. 9 is a graph of a gas supplying sequence for controlling source gases to form a vertical type superlattice layer by a MOCVD process in accordance with the present invention;

Figs. 10A and 10B are schematic views illustrating mechanisms of deposition and nondeposition of Ga atoms;

Fig. 11 is a graph showing relationships between a TMG gas supplying duration and a thickness of Ga layer (per cycle) grown on a JUST substrate;

Fig. 12 is a graph showing relationships between a AsH$_3$ gas supplying duration and a thickness of As layer (per cycle) grown on a JUST substrate;

Fig. 13 is a schematic view of a conventional gas source MBE apparatus; and

Fig. 14 is a graph of gas supplying sequence for controlling source gases to form a vertical type superlattice layer by a gas source MBE process in accordance with the present invention.

Principle embodiment of the present invention:

Referring to Figs. 4A to 4E, a compound semiconductor superlattice layer consisting of a first compound semiconductor AC and a second compound semiconductor BC is formed in accordance with the basic method of the present invention as follows:

As shown in Fig. 4A, a vicinal compound semiconductor substrate (misoriented substrate) 1 with atomic step stairs (steps and terraces) is prepared in a conventional manner. The substrate 1 has a slightly misoriented crystalline surface as the atomic stair steps of which steps have a step height being not necessarily a single atomic layer height and have a nonuniform terrace width. A buffer layer 2 of a compound semiconductor having the same lattice constant as that of the substrate 1 is epitaxially grown on the substrate 1 by an MOCVD method or a gas source MBE method with the result that its surface consists of uniform atomic steps having the step height equal to a monomolecular height, and a uniform terrace width.

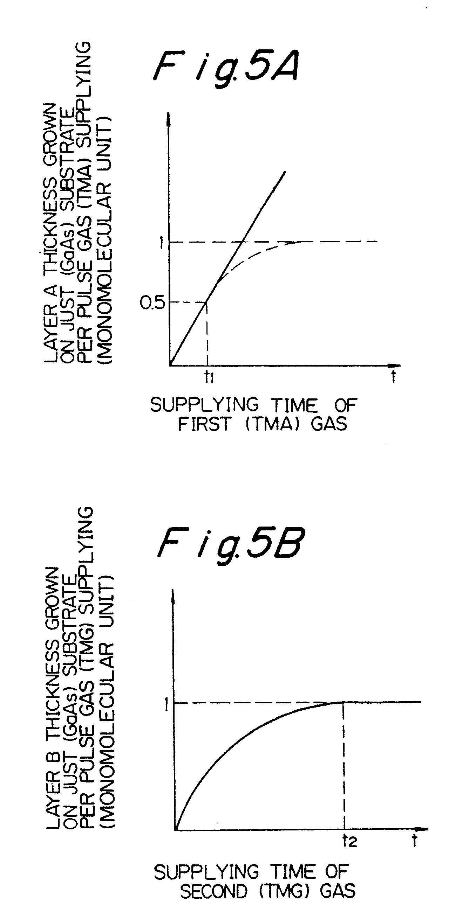

Next, a first source gas containing an element (atoms) A for the first compound semiconductor AC is pulsatively supplied under a growth condition that a surface diffusion length (distance) of the atoms A is larger than the step width (a step-flow growth mode), as shown in Fig. 4B, the atoms A preferentially adhere to each of the step edges and on the terrace (step) surface to grow each single atomic layer 11 in a lateral direction. In this case, the growth of the layer 11 is controlled essentially by using a relationship (indicated with a solid line or a broken line, as shown in Fig. 5A) between a thickness of the element A layer 11 and a supplying duration of the first source gas which relationship is obtained in a growth of the element A layer on a JUST substrate. The gas feeding duration is predetermined as "$t_1$" corresponding to a

half of the single atomic layer thickness (regarded as a half of the terrace width), so as to grow the layer 11 on the half of the step (terrace) width. The relationship indicated with the broken curve line is regarded as a self-limiting condition explained hereinafter.

After a stop of the supplying of the first source gas containing the element A, a second source gas containing an element B for the second compound semiconductor BC is pulsatively supplied under a self-limiting growth condition, as shown in Fig. 4C, a single atomic layer 12 is grown on the rest (half) of the terrace (on the exposed buffer layer portion: C atoms appear on the surface). When the exposed buffer layer is completely covered with the single atomic layer 12, the growth of the layer 12 is automatically stopped, because there is a self-limiting mechanism (i.e., a saturation condition) of the growth of the element B layer on a JUST substrate, as shown in Fig. 5B. Under the self-limiting condition, the atoms B are also not deposited (or absorbed) on the now formed layer 12 and also on the previous formed element A layer 11. For example, it is presumed that a metalorganic gas of the second source gas containing element B is not decomposed on the layer 11 to prevent the atoms B from being deposited thereon.

After a stop of the supplying of the second source gas containing the element B, a third source gas containing an element C for both the compound semiconductors AC and BC is also pulsatively supplied under the self-limiting growth condition, as shown in Fig. 4D, and the atoms C are deposited to grow a single atomic layer 13 on the layer 11 and 12. As a result, the layer 13 combines with the atomic layers 11 and 12 to form a monomolecular AC layer 14 and a monomolecular BC layer 15, as shown in Fig. 4D. The feeding of the third source gas is then stopped.

When the MOCVD process is adopted, it is preferable to pulsatively supply a hydrogen (H$_2$) gas after each of the first, second and third source gases to purge the residual source gas from a reactor of an MOCVD apparatus. On the other hand, when the gas source MBE process is adopted, it is preferable to make intervals between the supplying period of the first, second, and third source gases to remove one of the gases from a chamber of the apparatus.

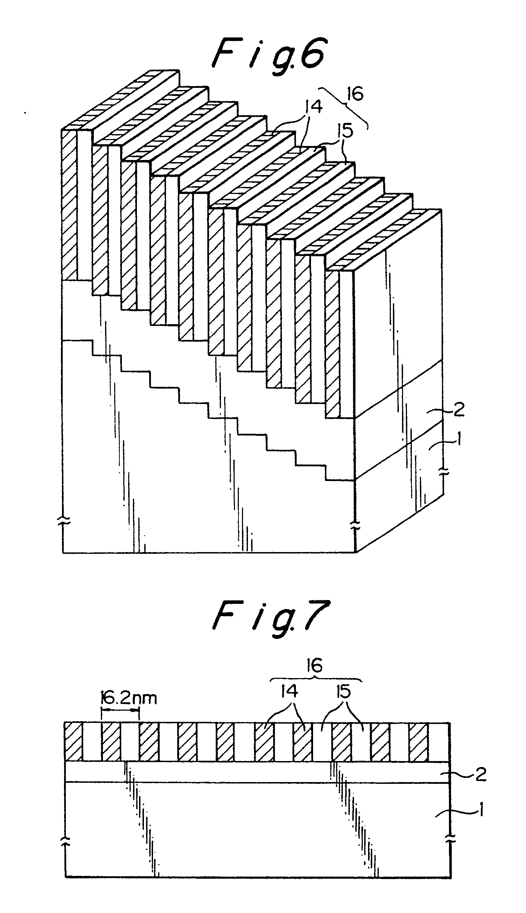

The above-mentioned gas supplying (deposition or growth) steps for the single atomic layers 11, 12 and 13 are periodically repeated to grow the first compound semiconductor AC layers 14 and second compound semiconductor BC layers 15 in a vertical direction, as shown in Fig. 4E, which layers 14 and 15 are alternately arranged in a lateral (transverse) direction to form a vertical type AC/BC superlattice layer 16. According to the present invention, one of the both AC/BC interfaces (a right-hand interface in Fig. 4E) of each of the BC layers 15 becomes flat and vertical, which prevents the whole interfaces from inclining and thus the oblique growth of the superlattice layer is as shown in Fig. 1E. Furthermore, in Fig. 4E the right-hand interface of each of the first compound semiconductor AC layer 14 becomes an uneven (nonflat) exaggeratedly illustrated. However, such unevenness is caused by dispersion of the deposited atom number being a few numbers, in practice, so that the unevenness of the interface does not cause a problem. In an ideal case, the AC/BC superlattice layer 16 shown in Fig. 6 is obtained, and in practice, it is possible to form the AC/BC superlattice layer 16 similar to that of Fig. 6. Furthermore, to easily understand the structure of the vertical type superlattice, although the vicinal angle ($\alpha = 1°$) is very small, the angle is exaggeratedly illustrated in Fig. 1A to 1E, 4A to 4E and 6. In practice, each of the atomic steps of the stairs has a monomolecular layer height (which is far smaller as compared with the terrace width), so that the substrate with the formed superlattice layer 16 can be observed, as shown in Fig. 7.

The elements A and B are atoms of group III, group II or group VI of a periodic table, and the element C is an atom of group V, group VI or group II. It is preferable that the group II element is zinc (Zn), the group III elements are aluminum (Al), gallium (Ga) and indium (In), the group V elements are arsenic (As) and phosphorus (P), and the group VI elements are selenium (Se), sulfur (S) and tellurium (Te).

Therefore, it is possible to form the superlattice layer on the suitable substrate, such as AlAs/GaAs superlattice on GaAs substrate, ZnSe/ZnS superlattice on GaAs substrate, InAs/GaAs superlattice on InP substrate, and ZnSe/ZnTe superlattice on InP substrate.

The obtained substrate with the vertical type superlattice layer formed in accordance with the present invention is used for semiconductor devices, such as a field-effect transistor (disclosed in K. TSUBAKI et al.: "New Field-Effect Transistor with Quantum Wire and Modulation-doped Heterostructures", Electronics Letters, 29th September, 1988, Vol. 24, No. 20, pp. 1267-1268 and K. TSUBAKI et al.: "Low Dimensional Electron Gas Field Effect Transistor Using Fractional Layer Superlattice", Extended Abstructs (The 49th, Autamn Meeting, 1988), The Japan Society of Applied Physics, 5a-C-11. p. 966), an electron mobility modulating transistor (disclosed in Y. TOKURA, K. TSUBAKI and N. SUSA: "Electronic States in an AlGaAs-GaAs ...", Surface Science 228 (1990) 280-282), an electron interference device (disclosed in K. Tsubaki et al.: "Large Current Electron Interference Devices Using Fractional Layer Superlattices (Wash Board Transistor)", Extended Abstructs (The 50th Autumn Meeting, 1989), The Japan Society of Applied Physics, 1p-S-16, p. 977).

Example 1

An AlAs/GaAs vertical type superlattice layer is formed on a GaAs single crystal substrate by using an MOCVD process in the following manner.

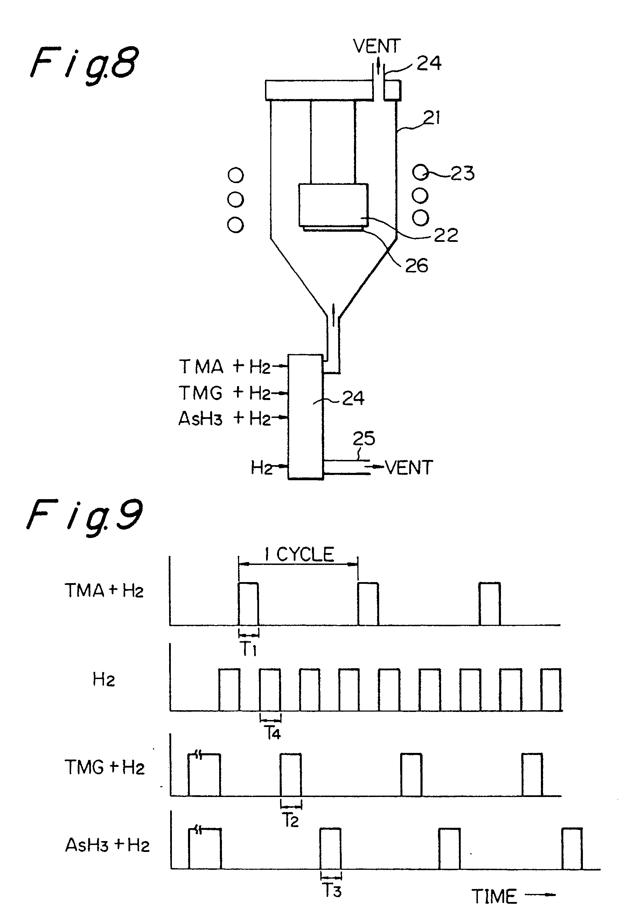

For epitaxially growing atomic layers of Al, Ga and As, a conventional vertical MOCVD apparatus shown in Fig. 8 is used. The apparatus comprises a reactor 21, a holder 22, an induction heating coil 23, a manifold 24 and vent pipes 24 and 25. The holder 22 holds a vicinal GaAs substrate 26 and heat it to a predetermined (growth) temperature. The vent pipes 24 and 25 are connected to a vacuum pump (not shown). The manifold 24 is provided with inlet pipes for supplying (1) a trimethylaluminum (TMA) gas and a hydrogen ($H_2$) carrier gas, (2) a tri-methylgallium (TMG) gas and a $H_2$ carrier gas, (3) an $AsH_3$ gas and a $H_2$ carrier gas and (4) a purge $H_2$ carrier gas. Each of the pipes has a mass flow controller and a switching valve for accurately supplying the gas therethrough.

First, a vicinal (100) GaAs substrate (wafer) 26 having a vicinal angle $\alpha$ of $1°$ is prepared by cutting a single crystal GaAs ingot, polishing, chemicaletching and setting it on the holder 22 within the reactor 21. The reactor 21 is evacuated to a vacuum pressure of $10^{-1}$ Torr (13 Pa) or less by a suitable vacuum pump. The substrate 26 is heated and maintained at a predetermined temperature of from 300 to $600°$ C, e.g., $450°$ C.

The TMG gas (and $H_2$ gas) and the $AsH_3$ gas (and $H_2$ gas) are simultaneously supplied (Fig. 9) into the reactor 21 though the manifold 24 to epitaxially grow a GaAs buffer layer 2 at the inside vacuum pressure of 20 Torr (2600 Pa) or less, as shown in Fig. 4A. The GaAs buffer layer 2 has atomic step stairs having one monomolecular layer height per step and uniform terrace (step) width (e.g., 16.2 nm). Then, the purge $H_2$ gas is supplied into the reactor 21 for a duration $T_4$, e.g., 1 second to purge away the TMG and $AsH_3$.

Next, in accordance with a gas control sequence shown in Fig. 9, the TMA gas (and $H_2$ gas), TMG gas (and $H_2$ gas), the $AsH_3$ gas (and $H_2$ gas) and the purge $H_2$ carrier gas are pulsatively fed supplied durations $T_1$, $T_2$, $T_3$ and $T_4$, respectively.

When the mixture gas of the TMA gas and the $H_2$ gas (40 sccm of TMA gas) is supplied at a flow rate of from 10 to 60 sccm (e.g., 40 sccm) and the substrate 1 is maintained at 400 to $530°$ JC (e.g.,

450°C), Al atoms decomposed from the TMA preferentially adhere to step edges and on the terraces to grow single atomic layers 11 in a lateral direction under the step-flow condition, as shown in Fig. 4B. The supplying duration $T_1$ (e.g., 1 second) of the TMA gas per pulse is set to make the growth distance of the Al single crystal layer (monoatomic layer) 11 just half of the step terrace width, as shown in Fig. 5A. Thus, the half of the terrace is covered with the Al atomic layer 11. Then, the purge $H_2$ gas is also supplied into the reactor 21 for, e.g., 1 second to purge away the TMA.

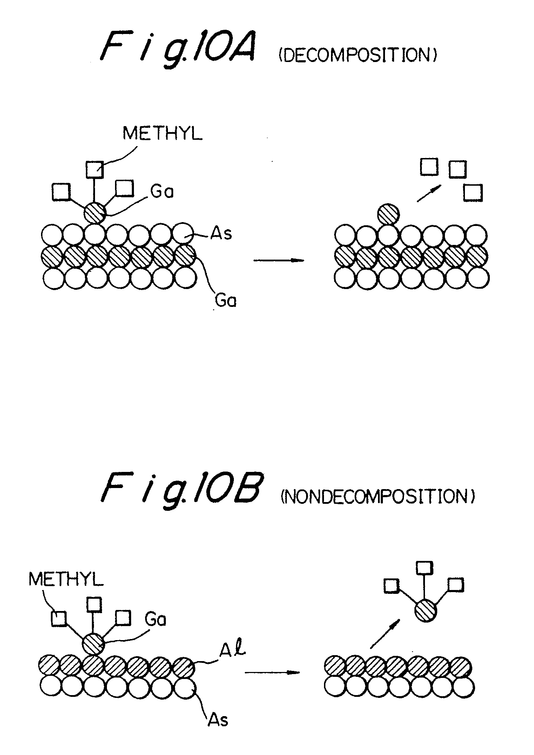

Next, when the mixture gas of the TMG gas and the $H_2$ gas is supplied at a flow rate of from 10 to 60 sccm (e.g., 40 sccm) and the substrate 1 is maintained at 400 to 530°C (e.g., 450°C), the TMG on the As atoms of the exposed remaining surface of the terrace (buffer GaAs layer 2) can decompose to deposit Ga atoms thereon, as shown in Fig. 10A, to grow single atomic layers 12 covering the remaining terrace, as shown in Fig. 4C, under suitable conditions. On the other hand, the TMG on the Al atoms of the formed atomic layer 11 does not decompose, so that the Al atoms combined with the methyl are not deposited, as shown in Fig. 10B. Moreover, the growth conditions (growth temperature, gas flow rate or the like) of the layers 12 are determined to attain a self-limiting condition, as shown in Fig. 5B. Thus, for example, the substrate temperature (i.e., the growth temperature) and the gas flow rate are decided at the above-mentioned values.

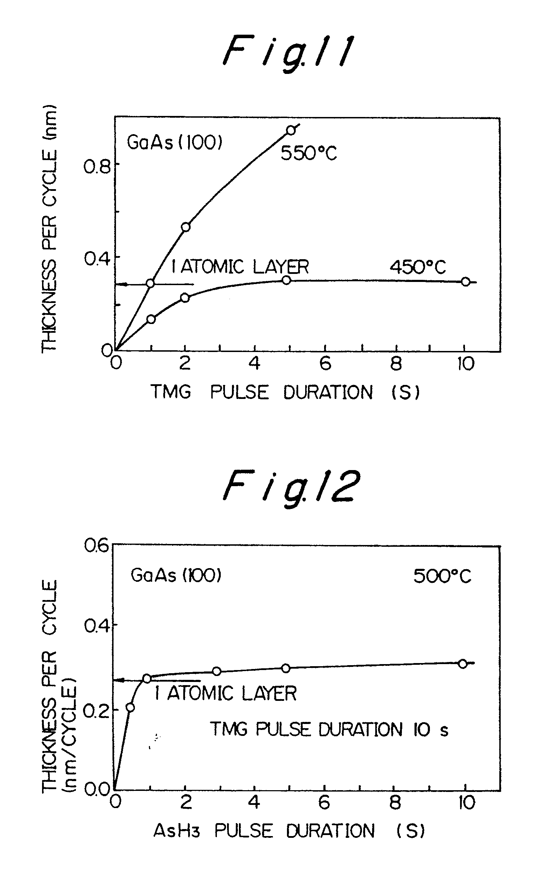

The self-limiting phenomenon of a Ga atomic layer formation appears, as shown in Fig. 11, under the following conditions.
Substrate: (100) GaAs JUST substrate
Growth temperature: 450°C, 500°C (comparative example)
Flow rate of TMG containing gas: TMG gas (40 sccm) and $H_2$ gas
Gas supplying duration per pulse: 1, 2, 5 and 10 seconds
Vacuum pressure: 20 Torr (3-10 Seconds) The curved line at 450°C proves that the growing effect is saturated to one atomic layer thickness. At 550°C the self-limiting mechanism does not appear.

Then, the purge $H_2$ gas is also supplied into the reactor 21 for, e.g., 1 second to purge away the TMG, as shown in Fig. 9.

Thereafter, when an $AsH_3$ gas (10%) diluted with the $H_2$ gas is fed at a flow rate of from 300 to 600 sccm (e.g., 480 sccm) and the substrate 1 is maintained at 400 to 500°C (e.g., 450°C), the As atoms deposited on the single atomic layers 11 and 12 to form single atomic layer 13, as shown in Fig. 4D, under the self-limiting condition. As the result, the As atoms chemically react with the Al atoms and the Ga atoms to form monomolecular AlAs layer 14 and monomolecular GaAs layers 14. The right side of the GaAs layer 13 exactly corresponds to the right side of the atomic step terrace.

The self-limiting phenomenon of a As atomic layer formation appears, as shown in Fig. 12, under the following conditions.
Substrate: (100)GaAs JUST substrate
Growth temperature: 500°C
Flow rate of $AsH_3$ gas: 480 sccm of $AsH_3$ (10%) diluted with $H_2$ gas
Gas feeding duration per pulse: 1-10 seconds
Vacuum pressure: 20 Torr (2700 Pa)
Underlying Ga atomic layer formation: mixture gas of TMG and $H_2$ for 10 sec. pulse supplying

The curved line at 500°C proves that the growing effect is saturated to slightly in excess of one atomic layer thickness.

The above-mentioned gas supplying (deposition or growth) steps for the single atomic layers 11, 12 and 13 are repeated (e.g., 1000 cycles) in accordance with the gas supplying sequence of Fig. 9 to grow the AlAs layers 14 and the GaAs layers 15 in a vertical direction whereby the GaAs/AlAs superlattice layer 16 (having a thickness of 250 nm) is formed, as shown in Fig. 4E.

## Example 2

An AlAs/GaAS vertical type superlattice layer is formed on a GaAs single crystal substrate by using a gas source MBE (MOMBE) process in the following manner.

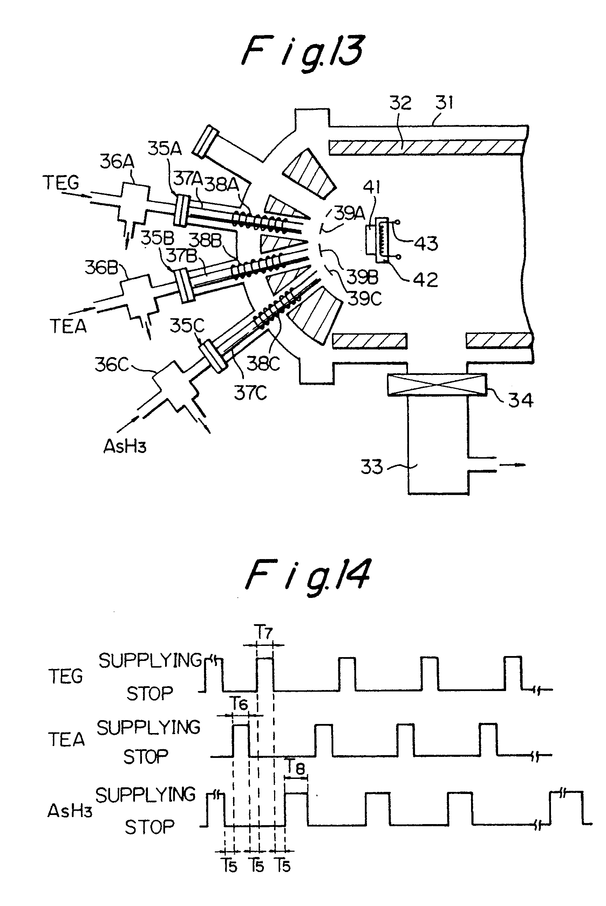

For epitaxially growing atomic layers of Al, Ga and As, a conventional gas source MBE apparatus shown in Fig. 13 is used. The apparatus comprises a chamber 31 with a cooling (liquid nitrogen) shroud (wall) 32, a vacuum pump 33 connected to the chamber 31 through a gate valve 34, and three source gas feeders 35A, 35B and 35C. The gas feeders 35A, 35B and 35C are provided with switching valves 36A, 36B and 36C, inlet pipes 37A, 37B and 37C, and heaters 38A, 38B and 38C, and are connected to a TEG gas source, a TEA gas source and a $AsH_3$ gas source, respectively. The heaters 38A and 38B heat the inlet pipes 37A and 37B to 80-150°C to prevent the condensation of the metalorganic gases. The chamber 31 has a holder 42 with a heater 43 and shutters 39A, 39B and 39C arranged between the holder 42 and the inlet pipes 37A, 37B and 37C, respectively. Feeding and nonfeeding (Stop) of the source gases are accurately controlled by controlling the switching valves 36A, 36B and 36C and shutters 39A, 39B and 39C. When the gas is not supplied into the chamber 31, it is discharged to an exhaust line from the switching valves 36A, 36B and 36C, so that an rapid switching of the gas is attained. The AsH₃ gas is cracked by heating it to about $1100°C$ with the heater 38C to feed As₂ into the chamber 31.

First, a vicinal (100)GaAs substrate (wafer) 41 having a vicinal angle $\alpha$ of $1°$ prepared for Example 1 is used and is set on the holder 42 within the chamber 31. The chamber 31 is evacuated to a vacuum pressure of $10^{-9}$ to $10^{-9}$ Torr by the vacuum pump 33. The substrate 41 is heated by the heater 43 and maintained at a predetermined temperature of from 300 to $650°C$, e.g., $580°C$.

The TMG gas and the AsH₃ gas are simultaneously supplied (Fig. 14) into the chamber 31 though the opened shutters 39A and 39C to epitaxially grow a GaAs buffer layer 2 at the inside vacuum pressure of $10^{-5}$ to $1.5 \times 10^{-4}$ Torr (e.g., $5 \times 10^{-5}$ Torr), as shown in Fig. 4A. The GaAs buffer layer 2 has atomic step stairs having one monomolecular layer height per step and uniform terrace (step) width (e.g., 16.2 nm) similar to Example 1. Then, the supplying of the gases is stopped for a duration $T_5$, e.g., 0.5 seconds to remove residual gases.

Next, in accordance with a gas control sequence shown in Fig. 14, the TEA gas, TEG gas and the AsH₃ gas are pulsatively fed for durations $T_6$, $T_7$ and $T_8$ at regular intervals (interruption durations) $T_5$.

When the TEA gas is fed at a flow rate of from 0.3 to 0.8 sccm (e.g., 0.5 sccm) and the substrate 1 is maintained at 300 to $600°C$ (e.g., $400°C$), Al atoms decomposed from the TEA preferentially adhere to step edges and on the terraces to grow single atomic layers 11 in a lateral direction under the step-flow condition, as shown in Fig. 4B. The supplying duration $T_6$ (e.g., 1 second) of the TEA gas per pulse is set to make the growth distance of the Al single crystal layer (monoatomic layer) 11 just half of the step terrace width, as shown in Fig. 5A. Thus, the half of the terrace is covered with the Al atomic layer 11. Then, the TEA gas is not supplied into the chamber 31 for, e.g., 0.5 seconds to take away the TEA.

Next, when the TEG gas is fed at a flow rate of from 0.5 to 2 sccm (e.g., 1 sccm) for the duration $T_7$ of 2 to 10 seconds (e.g., 3 seconds, and the substrate 1 is maintained at 300 to $480°C$ (e.g., $400°C$), the TEG on the As atoms of the exposed surface of the terrace (buffer GaAs layer 2) can decompose to deposit Ga atoms thereon to grow single atomic layers 12 covering the remaining terrace, as shown in Fig. 4C. On the other hand, the TEG on the Al atoms of the formed atomic layer 11 does not decompose, so that the Al atoms combined with the ethyl radical are not deposited. Moreover, the growth conditions (growth temperature, gas flow rate or the like) of the layers 12 are determined to attain a self-limiting condition, as shown in Fig. 5B. Thus, for example, the substrate temperature (i.e., the growth temperature) and the gas flow rate are decided at the above-mentioned value. Then, the TEG gas is not supplied into the chamber 31 for, e.g., 0.5 seconds to take away the TEG.

Thereafter, when an AsH₃ gas is supplied at a flow rate of from 1 to 8 sccm (e.g., 2 sccm) and the substrate 1 is maintained at 300 to $480°C$ (e.g., $400°C$) for the duration $T_8$ of 1 to 10 seconds (e.g., 2 seconds), the As atoms deposited on the single atomic layers 11 and 12 to form single atomic layer 13, as shown in Fig. 4D, under the self-limiting condition. As the result, the As atoms chemically react with the Al atoms and the Ga atoms to form monomolecular AlAs layer 14 and monomolecular GaAs layers 14. The right side of the GaAs layer 13 exactly corresponds to the right side of the atomic step terrace.

The above-mentioned gas supplying (deposition or growth) steps for the single atomic layers 11, 12 and 13 are repeated in accordance with the gas supplying sequence of Fig. 14 to grow the AlAs layers 14 and the GaAs layers 15 in a vertical direction whereby the GaAs/AlAs superlattice layer 16 is formed, as shown in Fig. 4E in the same manner as that of Example 1.

The obtained substrate with improved vertical type superlattice layer is used in a production of, e.g., a field-effect (FET) transistor in the following manner.

An n⁺-type (Si-doped) AlGaAs layer is epitaxially grown on the superlattice layer. A source electrode and a drain electrode are selectively formed on the AlGaAs layer and by a vapor deposition process and are alloyed with portions of the AlGaAs layer, the supper lattice layer, the buffer layer and the substrate to form a source region and a drain region. Then a gate electrode is formed on the AlGaAs layer between the source and drain electrodes to produce the FET transistor.

## Claims

1. A method of forming a vertical type superlattice layer (16) of first compound semiconductor AC thin layers (14) and second compound semiconductor BC thin layers (15) (wherein the elements A and B are atoms of group III, group II or group VI of the periodic table, and the element C is an atom of group V, group VI or group II), on an atomic step surface of a single crystal compound semiconductor substrate (1), comprising the step of repeating the following process steps (a), (b) and (c):

the process step (a) supplying a first source gas containing the element A to grow a single atomic A layer (11) from the edge of the atomic step in a lateral direction and on a portion of the atomic step width under a growth duration control;

the process step (b) supplying a second source gas containing the element B, under a self-limiting condition, to form a single atomic B layer (12) on the rest of the step width; and

the process step (c) supplying a third source gas containing the element C to combine the element C with said single atomic A layer (11) and with said single atomic B layer (12), so as to form a single molecular layer (14) of said first compound semiconductor AC and a single molecular layer (15) of said second compound semiconductor BC, respectively; so that said first compound semiconductor AC thin layers (14) and second compound semiconductor BC thin layers (15) are alternately set in a lateral direction and one of the interfaces of each of said second compound semiconductor BC thin layers to said first compound semiconductor AC thin layers is completely flat and vertical in relation to said said crystal substrate (1).

2. A method according to claim 1, wherein said atomic step surface having a step height of a single atomic height and a constant step width is formed by epitaxially growing a buffer compound semiconductor layer (2) having the same lattice constant as that of said substrate (1), on said single crystal compound semiconductor substrate (1) having a vicinal surface.

3. A method according to claim 2, wherein said element A is aluminum (Al), said element B is gallium (Ga), said element C is arsemic (As), said substrate (1) is GaAs, and said buffer layer is GaAs.

4. A method according to claim 1, wherein said element A is selenium Se), said element B is sulfur (S), said element C is zinc (Zn), and said substrate (1) is GaAs.

5. A method according to claim 1, wherein said element A is indium (In), said element B is gallium (Ga), said element C is arsemic (As), and said substrate (1) is InP.

6. A method according to claim 1, wherein said element A is selenium (Se), said element B is tellurium (Te), said element C is zinc (Zn), and said substrate (1) is InP.

7. A method according to any claim, wherein said process steps (a), (b) and (c) are periodically performed in a reactor (21) of a metalorganic chemical vapor deposition apparatus.

8. A method according to claim 7, wherein said substrate (1) is maintained at a temperature of from 400 to 530°C at said process step (b).

9. A method according to claims 1 to 6, wherein said process steps (a), (b) and (c) are periodically performed in a chamber (31) of a gas source molecular beam epitaxy apparatus.

10. A method according to claim 9, wherein said substrate (1) is maintained at a temperature of from 300 to 480°C at said process step (b).

11. A method according to any claim, wherein said process steps (a), (b) and (c) are pulsatively performed at regular intervals.

12. A method according to claim 11, wherein after each of said process steps (a), (b) and (c) a hydrogen gas is pulsatively fed to purge the source gas.

# F i g. IA

# F i g. IB

# F i g. IC

# F i g. ID

# F i g. IE

# F i g. 2

# Fig.3A

AlAs LAYER THICKNESS GROWN ON JUST SUBSTRATE PER PULSE TEA SUPPLYING (MONOMOLECULAR UNIT)

SUPPLYING TIME OF TEA

# Fig.3B

GaAs LAYER THICKNESS GROWN ON JUST SUBSTRATE PER PULSE TEG SUPPLYING (MONOMOLECULAR UNIT)

SUPPLYING TIME OF TEG

Fig.4A

16.2nm

α=1°

2

1

Fig.4B

11

2

1

Fig.4C

11

12

2

1

*Fig.4D*

*Fig.4E*

# Fig.5A

LAYER A THICKNESS GROWN
ON JUST (GaAs) SUBSTRATE
PER PULSE GAS (TMA) SUPPLYING
(MONOMOLECULAR UNIT)

1

0.5

t₁

t

SUPPLYING TIME OF
FIRST (TMA) GAS

# Fig.5B

LAYER B THICKNESS GROWN
ON JUST (GaAs) SUBSTRATE
PER PULSE GAS (TMG) SUPPLYING
(MONOMOLECULAR UNIT)

1

t₂

t

SUPPLYING TIME OF
SECOND (TMG) GAS

## Fig.6

## Fig.7

# Fig.8

VENT ——24

21

23

22

26

TMA + H₂ →

TMG + H₂ →    24

AsH₃ + H₂ →

25

H₂ →    →VENT

# Fig.9

I CYCLE

TMA + H₂

T₁

H₂

T₄

TMG + H₂

T₂

AsH₃ + H₂

T₃

TIME ——

# F i g.l0A (DECOMPOSITION)

METHYL

Ga

As

Ga

# F i g.l0B (NONDECOMPOSITION)

METHYL

Ga

Aℓ

As

# *Fig.11*

# *Fig.12*

## Fig.13

## Fig.14